# EUROPÄISCHE PATENTSCHRIFT

(11) **EP 2 381 753 B1**
(45) Veröffentlichungstag und Bekanntmachung des Hinweises auf die Patenterteilung: **31.07.2019**
(21) Anmeldenummer: 11162047.2
(22) Anmeldetag: 12.04.2011
(51) Int. Cl.: H05K 5/02, H05K 5/00, B60R 16/02, H01R 13/52, H02G 3/08, B60T 8/36, G09F 3/02

(54) **Gehäuse mit Partikelsperreinrichtung**
Casing with particle blocker
Boîtier doté d'un dispositif de verrouillage de particules

(30) Priorität: 21.04.2010 DE 102010028034
(43) Veröffentlichungstag der Anmeldung: 26.10.2011
(73) Patentinhaber: Robert Bosch GmbH, 70442 Stuttgart (DE)
(72) Erfinder: Zadach, Peter, 72770, Reutlingen (DE)

(56) Entgegenhaltungen:
- DE-A1- 3 813 138
- DE-A1- 4 006 096
- DE-A1- 4 321 331
- DE-A1-102004 054 344
- DE-A1-102005 015 768
- GB-A- 1 156 084
- US-A- 3 516 111
- US-A- 5 520 447
- US-A- 5 928 465

## Beschreibung

### Stand der Technik

Die vorliegende Erfindung betrifft ein Gehäuse für ein Steuergerät mit einer Partikelsperreinrichtung, welche im Gehäuse ausgebildete Durchgangsöffnungen verschließt.

Gehäuse werden im Stand der Technik beispielsweise in Steuergeräten zur Steuerung von Antiblockiersystemen oder elektronischen Stabilitätsprogrammen in Fahrzeugen verwendet. Derartige Steuergeräte weisen üblicherweise einen Zwischenboden auf, wodurch das Gehäuse in zwei Bereiche unterteilt wird. Hierbei ist einer der Gehäusebereiche als Spulenraum zur Aufnahme einer Vielzahl von Spulen vorgesehen. Durch verschiedene Öffnungen in diesem Zwischenboden des Gehäuses können dabei Korrosionspartikel vom Spulenraum in den zweiten Gehäusebereich gelangen, in welchem üblicherweise ein elektronischer Schaltungsträger angeordnet ist. Hierdurch können Störungen am Schaltungsträger auftreten. Die Öffnungen im Gehäuse bzw. im Zwischenboden dienen hierbei insbesondere zur Zentrierung des Steuergeräts, so dass auf diese Öffnungen nicht verzichtet werden kann. Diese Öffnungen werden jedoch beispielsweise auch bei Wartungsarbeiten am Steuergerät wieder benötigt.

Aus der Offenlegungsschrift DE4006096 A1 ist eine hydraulische Bremsvorrichtung bekannt. Bei dieser ist ein Keramikträger mit einem U-förmigen Träger befestigt. Der U-förmige Träger ist ferner mit einem Gehäuseteil verschlossen. Das Gehäuseteil weist eine Aussparung auf mit einem in der Aussparung angeordnetem einknöpfbarem elastischen Kunststoffstopfen. Aus diesem ist dann eine mit dem Keramikträger verbundene Anschlussleitung aus dem Gehäuse geführt.

Die Patentschrift US 3516111 offenbart einen selbst verschließenden Durchführungsstopfen.

### Offenbarung der Erfindung

Das erfindungsgemäße Gehäuse für ein Steuergerät mit den Merkmalen des Anspruchs 1 weist demgegenüber den Vorteil auf, dass die Gefahr von Verschmutzungen im Gehäuse signifikant reduziert werden kann. Die erfindungsgemäße Lösung zeichnet sich dabei insbesondere durch ihre Einfachheit und Kostengünstigkeit aus. Dabei werden die Durchgangsöffnungen erfindungsgemäß so verschlossen, dass trotzdem noch auf sie zugegriffen werden kann, d.h., dass z.B. ein Zentrierungsstift o.ä. immer noch durch die Öffnung hindurchgesteckt werden kann. Dies wird erfindungsgemäß dadurch erreicht, dass eine Partikelsperreinrichtung über der Durchgangsöffnung angeordnet ist, welche wenigstens einen Schlitz aufweist, welcher über der Durchgangsöffnung positioniert ist. Somit kann beispielsweise ein Zentrierstift durch die Partikelsperreinrichtung im Bereich des Schlitzes hindurchgesteckt werden und nach erfolgter Nutzung der Durchgangsöffnung verschließt sich die Partikelsperreinrichtung aufgrund ihrer Eigenspannungen wieder selbsttätig.

Die Partikelsperreinrichtung ist dabei ein Aufkleber, welcher über die Durchgangsöffnung geklebt wird. Aufkleber können sehr einfach und kostengünstig hergestellt werden und ferner können auch die Schlitze einfach in den Aufkleber eingebracht werden. Ein weiterer Vorteil des Aufklebers ist, dass dieser gegebenenfalls nach einem falschen Aufkleben wieder abgezogen werden kann. Aufkleber bilden somit eine optimale Lösung für das vorhandene Problem des flexiblen Absperrens der Durchgangsöffnungen gegenüber einem unerwünschten Durchtreten von kleinen Partikeln.

Die Unteransprüche zeigen bevorzugte Weiterbildungen der Erfindung.

Besonders bevorzugt umfasst die Partikelsperreinrichtung genau zwei Schlitze, welche zueinander in einem Winkel von 90° angeordnet sind und welche ein Kreuz bilden. Hierdurch ergibt sich eine relativ große Öffnungsfläche für einen durch die Durchgangsöffnung hindurchgeschobenen Gegenstand, wie z.B. einen Zentrierstift.

Alternativ weist die Partikelsperreinrichtung genau drei sich schneidende Schlitze auf, wobei einander benachbarte Schlitze zueinander in einem Winkel von 60° angeordnet sind. Hierdurch ergibt sich ein sternförmiges Schlitzgebilde, bei dem beim Hindurchstecken eines Gegenstands ein geringerer Widerstand als beispielsweise bei einem oder zwei Schlitzen entgegengebracht wird.

Der Aufkleber ist vorzugsweise mit einem im Wesentlichen kreisförmigen Außenumfang gebildet. Dies ermöglicht eine einfache Zentrierung des Aufklebers über den üblicherweise kreisrunden Durchgangsöffnungen.

Um zu vermeiden, dass ein durch den Aufkleber hindurchgeführter Gegenstand am Aufkleber kleben bleibt, weist der Aufkleber vorzugsweise Klebstoff lediglich an einem äußeren Umfangsbereich auf, mit welchem der Aufkleber auf das Gehäuse über der Durchgangsöffnung aufgeklebt ist.

Gemäß einer weiteren bevorzugten Ausgestaltung der Erfindung ist die Durchgangsöffnung in einem Zwischenboden oder einer Zwischenwand des Gehäuses ausgebildet, wodurch das Gehäuse in zwei Bereiche unterteilt wird.

Gemäß einer weiteren bevorzugten Ausgestaltung der Erfindung ist jeweils eine Partikelsperreinrichtung an beiden Seiten der Durchgangsöffnung vorgesehen. Hierdurch wird eine besonders sichere Abdichtung erreicht.

### Zeichnung

Nachfolgend wird ein bevorzugtes Ausführungsbeispiel der Erfindung unter Bezugnahme auf die begleitende Zeichnung im Detail beschrieben. In der Zeichnung ist:
- Figur 1: eine schematische Schnittansicht eines Gehäuses gemäß einem Ausführungsbeispiel der Erfindung,
- Figur 2: eine schematische Draufsicht auf eine Partikelsperreinrichtung von Figur 1,
- Figur 3: eine schematische Ansicht der Partikelsperreinrichtung von unten,
- Figur 4: eine perspektivische Ansicht der Partikelsperreinrichtung im eine Durchgangsöffnung verschließenden Zustand, und
- Figur 5: eine perspektivische Ansicht der Partikelsperreinrichtung von Figur 4, wenn ein Zentrierstift durch die Durchgangsöffnung hindurchgeführt wird.

### Bevorzugte Ausführungsform der Erfindung

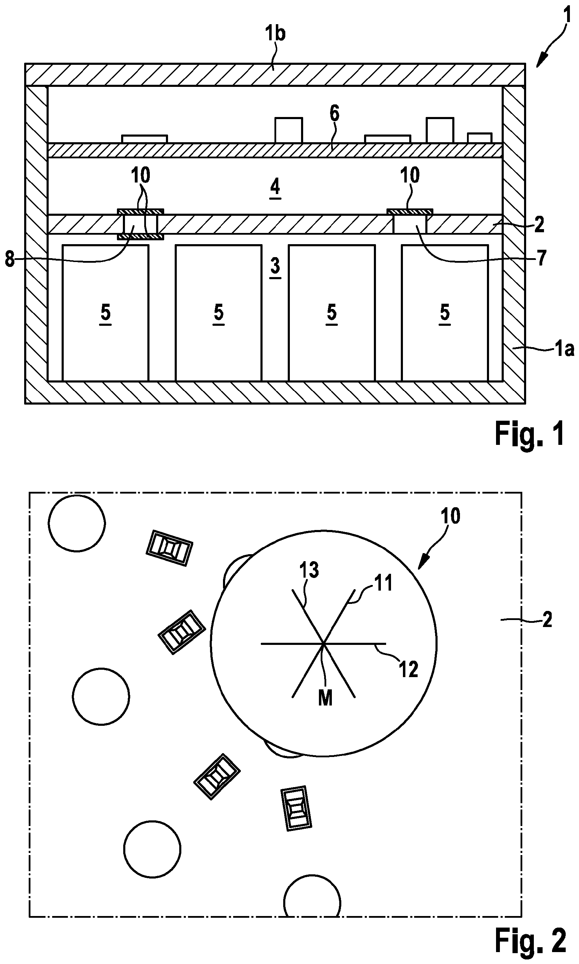

Nachfolgend wird unter Bezugnahme auf die Figuren 1 bis 5 ein Gehäuse 1 gemäß einem bevorzugten Ausführungsbeispiel der Erfindung im Detail beschrieben.

Figur 1 zeigt eine schematische Schnittansicht des Gehäuses 1, welches einen Basisbereich 1a und einen Deckel 1b umfasst. Ferner ist im Gehäuse 1 ein Zwischenboden 2 vorgesehen, welcher das Innere des Gehäuses 1 in einen ersten Bereich 3 und einen zweiten Bereich 4 unterteilt. Im ersten Bereich 3 ist eine Vielzahl von Spulen 5 angeordnet und im zweiten Bereich 4 ist eine bestückte Leiterplatte 6 oder alternativ andere Bauteile angeordnet. Im Zwischenboden 2 sind weiter eine erste Durchgangsöffnung 7 und eine zweite Durchgangsöffnung 8 vorgesehen.

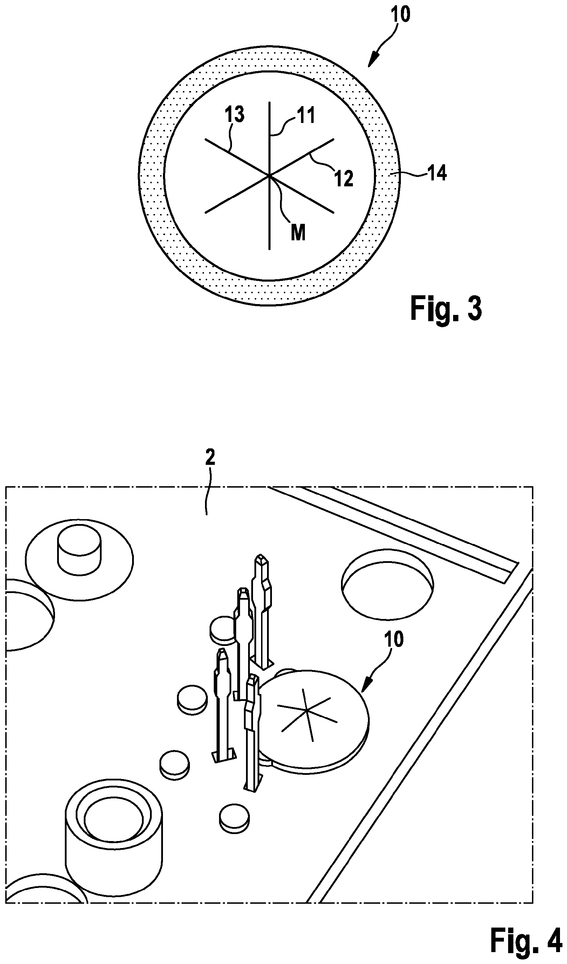

Wie aus Figur 1 ersichtlich ist, sind die erste und zweite Durchgangsöffnung 7, 8 mittels einer als Aufkleber 10 ausgebildeten Partikelsperreinrichtung verschlossen. Wie in Figur 1 gezeigt, sind die Aufkleber 10 dabei über die Durchgangsöffnungen 7 und 8 aufgeklebt und verschließen diese. Bei der zweiten Durchgangsöffnung 8 ist dabei an beiden Seiten der Durchgangsöffnung ein Aufkleber 10 angeordnet. Hierdurch ergibt sich eine noch sichere Trennung der beiden Bereiche 3, 4 des Gehäuses 1, ohne dass dadurch Einschränkungen hinsichtlich einer Hindurchführbarkeit eines Zentrierstifts 9 oder dgl. resultieren. Wie insbesondere aus den Figuren 2 und 3 ersichtlich ist, weisen die Aufkleber 10 insgesamt drei Schlitze, nämlich einen ersten Schlitz 11, einen zweiten Schlitz 12 und einen dritten Schlitz 13 auf. Die drei Schlitze sind dabei derart angeordnet, dass sie voneinander jeweils in einem Winkel von 60° angeordnet sind. Hierdurch ergibt sich ein sternförmiges Schlitzmuster, wobei ein Mittelpunkt M, in welchem sich die Schlitze schneiden, in einem Mittelpunkt des Aufklebers 10 liegt. Wie weiter aus Figur 3 ersichtlich ist, welche die Unterseite des Aufklebers 10 zeigt, ist ein Klebebereich 14 am Aufkleber 10 lediglich an einem äußeren Ringumfangsbereich vorgesehen. Hierdurch wird vermieden, dass Klebstoff im Bereich der Schlitze vorhanden ist und die Schlitze gegebenenfalls verkleben, wodurch ein Durchstoßen des Aufklebers verschlechtert werden könnte.

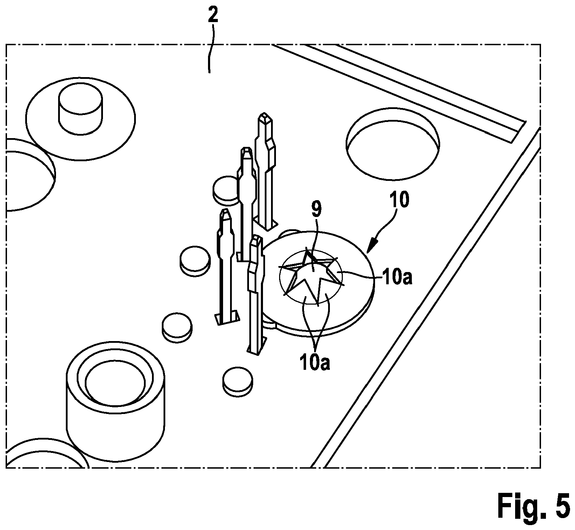

Ein derartiges Durchstoßen des Aufklebers 10 mit einem Zentrierstift 9 ist in Figur 5 dargestellt. Wie hier ersichtlich ist, drückt der Zentrierstift 9 die durch das sternförmige Schnittmuster gebildeten einzelnen, dreieckförmigen Lappen 10a des Aufklebers 10 zur Seite, so dass der Zentrierstift 9 problemlos durch die Durchgangsöffnung sowie den darüber angeordneten Aufkleber 10 hindurchgeführt werden kann. Es sei angemerkt, dass erfindungsgemäß eine Richtung, in welcher der Aufkleber 10 durchstoßen wird, egal ist, d.h., der Zentrierstift 9 kann von beiden Richtungen aus durch den Aufkleber 10 hindurchgeführt werden.

Nach einem Zurückziehen des Zentrierstifts 9 erfolgt eine selbsttätige Rückstellung der dreieckförmigen Lappen 10a, da diese aufgrund der Einschnitte in den Aufkleber eine gewisse Eigenelastizität aufweisen. Hierbei sei angemerkt, dass besonders bevorzugt als Material für den Aufkleber 10 ein zumindest teilweise elastisches Material, z.B. mit einem gummielastischen Anteil, verwendet wird, um eine sichere Rückstellung der dreieckförmigen Lappen 10a in die in den Figuren 2 und 4 gezeigte Ausgangsposition sicherzustellen. Hierdurch kann ein mehrmaliges Durchstoßen des Aufklebers mit einem Zentrierstift 9 oder dgl. ermöglicht werden.

Das erfindungsgemäße Gehäuse 1 wird besonders bevorzugt für Steuergeräte in Fahrzeugen, insbesondere für ABS- und/oder ESP-Steuergeräte verwendet.

## Patentansprüche

1. Gehäuse für ein Steuergerät, umfassend:
- wenigstens eine in einem Gehäuseteil ausgebildete Durchgangsöffnung (7, 8), und
- eine Partikelsperreinrichtung (10), welche an der Durchgangsöffnung (7, 8) angeordnet ist und diese verschließt, wobei die Partikelsperreinrichtung (10) wenigstens einen Schlitz (11, 12, 13) aufweist, welcher über der Durchgangsöffnung (7, 8) positioniert ist und die Partikelsperreinrichtung (10) ein Aufkleber ist.

2. Gehäuse nach Anspruch 1, **dadurch gekennzeichnet, dass** die Partikelsperreinrichtung genau zwei Schlitze aufweist, welche zueinander in einem Winkel von 90° angeordnet sind und ein Kreuz bilden.

3. Gehäuse nach Anspruch 1, **dadurch gekennzeichnet, dass** die Partikelsperreinrichtung (10) genau drei sich schneidende Schlitze aufweist, wobei einander benachbarte Schlitze (11, 12, 13) zueinander in einem Winkel von 60° angeordnet sind.

4. Gehäuse nach einem der vorhergehenden Ansprüche, **dadurch gekennzeichnet, dass** die Partikelsperreinrichtung (10) einen im Wesentlichen kreisförmigen Außenumfang aufweist.

5. Gehäuse nach einem der Ansprüche 1 bis 4, **dadurch gekennzeichnet, dass** der Aufkleber lediglich an seiner Unterseite Klebstoff an einem äußeren Umfangsbereich (14) aufweist.

6. Gehäuse nach einem der vorhergehenden Ansprüche, **dadurch gekennzeichnet, dass** die Durchgangsöffnung (7, 8) in einem Zwischenboden (2) des Gehäuses, welcher das Gehäuse in einen ersten und zweiten Bereich (3, 4) unterteilt, angeordnet ist.

7. Gehäuse nach einem der vorhergehenden Ansprüche, **dadurch gekennzeichnet, dass** eine Partikelsperreinrichtung (10) an beiden Seiten der Durchgangsöffnung (7, 8) angeordnet ist.

## Claims

1. Casing for a control device, comprising:
- at least one through-opening (7, 8) formed in one part of the casing and
- a particle blocker (10), which is arranged at the through-opening (7, 8) and closes it, wherein the particle blocker (10) has at least one slit (11, 12, 13), which is positioned over the through-opening (7, 8), and the particle blocker (10) is a sticker.

2. Casing according to Claim 1, **characterized in that** the particle blocker has precisely two slits, which are arranged at an angle of 90° in relation to one another and form a cross.

3. Casing according to Claim 1, **characterized in that** the particle blocker (10) has precisely three intersecting slits, wherein adjacent slits (11, 12, 13) are arranged at an angle of 60° in relation to one another.

4. Casing according to one of the preceding claims, **characterized in that** the particle blocker (10) has a substantially circular outer circumference.

5. Casing according to one of Claims 1 to 4, **characterized in that** the sticker has just on its underside adhesive at an outer circumferential region (14).

6. Casing according to one of the preceding claims, **characterized in that** the through-opening (7, 8) is arranged in an intermediate bottom (2) of the casing that divides the casing into a first region (3) and a second region (4).

7. Casing according to one of the preceding claims, **characterized in that** a particle blocker (10) is arranged on both sides of the through-opening (7, 8) .

## Revendications

1. Boîtier pour un contrôleur, comprenant :
- au moins une ouverture de passage (7, 8) configurée dans une partie de boîtier et
- un dispositif de blocage de particules (10), lequel est disposé au niveau de l'ouverture de passage (7, 8) et ferme celle-ci, le dispositif de blocage de particules (10) possédant au moins une fente (11, 12, 13) qui est positionnée au-dessus de l'ouverture de passage (7, 8) et le dispositif de blocage de particules (10) étant une étiquette autocollante.

2. Boîtier selon la revendication 1, **caractérisé en ce que** le dispositif de blocage de particules possède exactement deux fentes qui sont disposées selon un angle de 90° l'une par rapport à l'autre et forment une croix.

3. Boîtier selon la revendication 1, **caractérisé en ce que** le dispositif de blocage de particules (10) possède exactement trois fentes qui se croisent, les fentes (11, 12, 13) voisines les unes des autres étant disposées selon un angle de 60° l'une par rapport à l'autre.

4. Boîtier selon l'une des revendications précédentes, **caractérisé en ce que** le dispositif de blocage de particules (10) possède un pourtour extérieur sensiblement en forme de cercle.

5. Boîtier selon l'une des revendications 1 à 4, **caractérisé en ce que** l'étiquette autocollante possède un agent adhésif au niveau d'une zone périphérique (14) externe uniquement au niveau de son côté inférieur.

6. Boîtier selon l'une des revendications précédentes, **caractérisé en ce que** l'ouverture de passage (7, 8) est disposée dans un fond intermédiaire (2) du boîtier, lequel divise le boîtier en une première et une deuxième zone (3, 4).

7. Boîtier selon l'une des revendications précédentes, **caractérisé en ce qu'**un dispositif de blocage de particules (10) est disposé des deux côtés de l'ouverture de passage (7, 8).
